# EUROPEAN PATENT APPLICATION

(11) **EP 1 339 212 A2**
(43) Date of publication of application: **27.08.2003**
(21) Application number: 02028846.0
(22) Date of filing: 23.12.2002
(51) Int. Cl.: H04N 1/21, H04N 101/00

(54) **Image capture apparatus with backup memory**

(30) Priority: 20.02.2002 US 357651 P
(71) Applicant: Creo IL. Ltd., 46103 Herzlia Pituah (IL)
(72) Inventor: Kalinski, Dov, 45219 Hod HaSharon (IL)
(74) Representative: Hofmann, Harald

(57) **Abstract**

An image capture apparatus consists of an image capture sensor for capturing a current image, a memory bank for storing image data, and a memory controller. The memory bank contains two or more memory units, which store copies of images captured by the sensor. The memory controller stores newly captured images in at least two of the memory units, thus creating one or more backup copies of the image data.

## Description

The present invention relates to digital photography and more particularly but not exclusively to image backup capability for digital cameras.

Digital photography is a rapidly expanding field. One important factor contributing to this growth are improvements in camera storage memories, which permit photographers to store greater numbers of files in the camera before downloading the files for printing or further processing. However, as the number of images stored in a camera memory increases so does the number of images that can be affected if the camera memory malfunctions or is lost. Current technology allows backup to be performed only after the images are downloaded from the memory onto a computer. Unfortunately, backing up the image after download does not protect the user from a multiplicity of problems which may affect the image data while still stored in camera memory, including data corruption during image processing or camera memory failure.

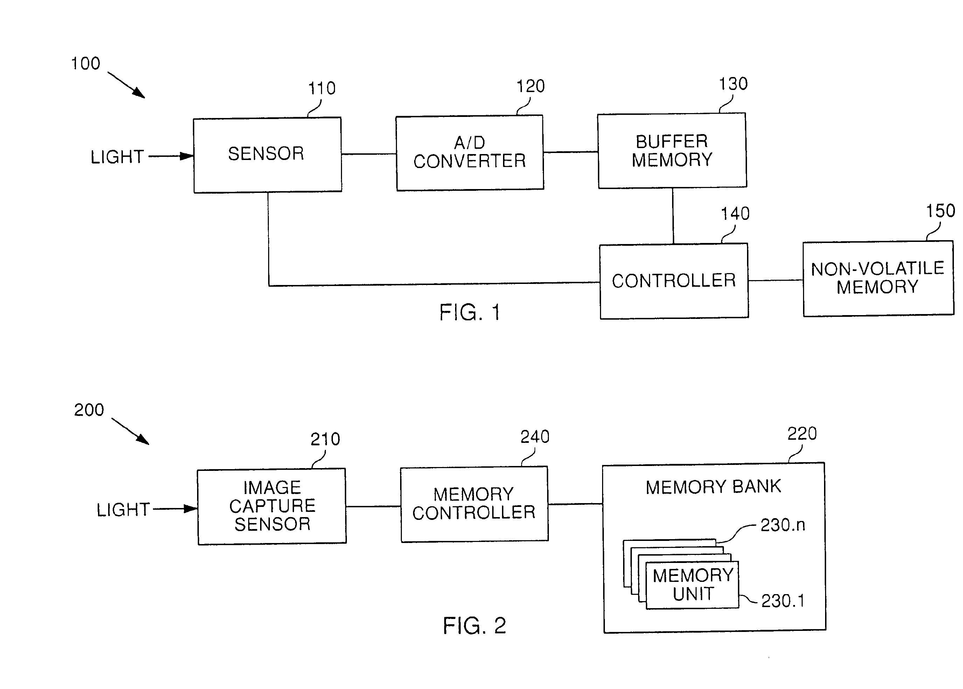

Figure 1 shows the architecture of a typical digital camera. Light entering digital camera 100 is captured on a two-dimensional sensor 110 (usually a CCD or CMOS sensor). A/D converter 120 reads the analog signal from the sensor in a pixel-by-pixel, line-by-line ordering, and converts the analog sensor values into a digital signal. The captured image is then transferred into buffer memory 130. The data is generally kept in the buffer memory temporarily, and is then written by controller 140 into a non-volatile memory device 150, such as a hard disk or a flash memory card. The non-volatile memory 150 is typically removable, for replacement with another memory or for image download. Buffer memory 130 is required for processing the data, e.g., adjusting it according to the sensor's known non-uniformity and/or for compression purposes, as well as for matching the different data rates of reading from the sensor and writing into the non-volatile memory device. In addition to controlling data transfer, controller 140 controls other elements of the photographic process, including the operation of sensor 110 and the required data processing.

In US Patent No. 6,148,149 to Kagle, a digital camera having a non-volatile memory and a removable memory is provided. The removable memory can be removed from the camera and plugged into a computer or other device for viewing or downloading the stored images. A similar approach is found in US Patent No. 6,343,155 to Chui et al. In Chui et al., each image, after it has been processed by the data processing circuitry, is typically stored in a nonvolatile memory storage device, preferably implemented as a removable memory card. This enables the camera's user to remove one memory card, plug in another, and then take additional pictures. In both Kagle and Chui et al., the auxiliary memory serves to increase the storage capacity of the camera, but does not provide picture data backup capability.

U.S. Patent No. 6,397,314 to Estakhri et al. provides a system for increasing the memory performance of flash memory devices by writing sectors simultaneously to multiple flash memory devices. Estakhri et al. disclose a digital system having a controller semiconductor device coupled to a host and a nonvolatile memory bank including a plurality of nonvolatile memory devices. The controller transfers information, organized in sectors, between the host and the nonvolatile memory bank, and stores and reads two bytes of information relating to the same sector simultaneously within two nonvolatile memory devices. The information being written to each memory device, however, is just a portion of the data being saved; there is no duplication or backup of the stored information.

The DCS Pro Back Plus digital camera back, available from Eastman Kodak Company of Rochester, NY, includes two slots for storage Compact Flash cards, which can be solid state or IBM Microdrives. Only one card is active at a time.

Unlike digital scanners, where the captured image is static and may repeatedly be scanned if necessary, digital cameras capture a non-recurring scene, and therefore data lost or corrupted is not retrievable. There is therefore a need for a digital camera with a reduced risk of losing image data.

Unlike digital scanners, where the captured image is static and may repeatedly be scanned if necessary, digital cameras generally capture a non-recurring scene, and therefore data lost or corrupted is not retrievable. There is therefore a need for a digital camera which reduces the risk of losing image data.

According to a first aspect of the present invention there is provided an image capture apparatus, which provides a backup copy of the image data. The image capture apparatus consists of an image capture sensor, a memory controller, and a memory bank. The image capture sensor captures a current image. The memory bank stores image data in more than one memory units, for. The memory controller, which is operatively associated with the sensor and the memory bank, stores the current image in each of at least two of the memory units.

Preferably, the memory units comprise non-volatile memory. The non-volatile memory may consist of one of a group of memory types including: flash memory, compact flash memory, smart card, and hard drive.

Preferably, at least one of the memory units is removable.

Preferably, the memory units are physically separable.

Preferably, the image capture apparatus is operable to store the current image in the memory units in parallel.

Preferably, the image capture apparatus is operable to store the current image in the memory units sequentially.

Preferably, one of the memory units comprises a recent image memory operable to store a predetermined number of most recently captured images. If storing a new current image in the recent image memory would exceed the predetermined number, a least recent image is removed from the recent image memory prior to storing the current image.

Preferably, the memory controller is operable to store the backup copy of the current image during image capture apparatus idle time.

Preferably, the image capture apparatus further consists of a converter, for converting current image data from the sensor into a digitized image.

Preferably, the image capture apparatus further consists of a buffer memory, for providing temporary storage of the current image.

Preferably, the image capture apparatus further consists of an image processor for processing image data.

In the preferred embodiment, the image processor performs the processing separately on the backup copy of the image, thus providing a processed backup copy of the image data. Preferably, the image processing is performed upon data stored in a buffer memory. The processing performed on the image preferably is image compression. In the preferred embodiment, the processing compensates for sensor non-uniformity. Preferably, the processing provides data rate matching to compensate for unequal rates of reading data from the sensor and storing the sensor data in the memory units. In a further preferred embodiment, the processing provides image resolution reduction.

Preferably, at least one of the memory units is switchable between storing primary copies of images and storing backup copies of images, thereby providing primary image memory expansion capability.

Preferably, the number of backup copies provided is user selectable.

According to a second aspect of the present invention there is provided a method for providing a backup copy of captured image data. The method consists of capturing a current image, and storing the current image in each of at least two memory units.

Preferably, the memory units are non-volatile memories.

Preferably, the memory units are physically separable.

Preferably, storing the current image in the memory units comprises storing the current image data in the memory units sequentially.

Preferably, storing the current image in the memory units comprises storing the current image data in the memory units in parallel.

Preferably, one of the memory units contains a recent image memory for storing a predetermined number of most recently captured images. Storing a new current image in the recent image memory consists of the following steps: determining a number of images stored in the recent image memory, if the number of images equals the predetermined number, removing a least recent image from the recent image memory, and storing the new current image in the recent image memory.

Preferably, the method contains the additional step of digitizing the current image.

Preferably, the method contains the additional step of processing image data.

Preferably, processing image data consists of compressing the image data.

Preferably, processing image data consists of compensating for sensor non-uniformity.

Preferably, processing image data consists of matching data rates to compensate for unequal rates for reading sensor data and storing the sensor data in the memory units.

Preferably, processing image data consists of reducing image resolution.

Preferably, the method contains the additional step of downloading image data from at least one of the memory units to a computer.

Preferably, the method contains the additional step of selecting a number of backup copies to be stored in the memory units.

Unless otherwise defined, all technical and scientific terms used herein have the same meaning as commonly understood by one of ordinary skill in the art to which this invention belongs. Although methods and materials similar or equivalent to those described herein can be used in the practice or testing of the present invention, suitable methods and materials are described below. In case of conflict, the patent specification, including definitions, will control. In addition, the materials, methods, and examples are illustrative only and not intended to be limiting.

Implementation of the method and system of the present invention involves performing or completing selected tasks or steps manually, automatically, or a combination thereof. Moreover, according to actual instrumentation and equipment of preferred embodiments of the method and system of the present invention, several selected steps could be implemented by hardware or by software on any operating system of any firmware or a combination thereof. For example, as hardware, selected steps of the invention could be implemented as a chip or a circuit. As software, selected steps of the invention could be implemented as a plurality of software instructions being executed by a computer using any suitable operating system. In any case, selected steps of the method and system of the invention could be described as being performed by a data processor, such as a computing platform for executing a plurality of instructions.

For a better understanding of the invention and to show how the same may be carried into effect, reference will now be made, purely by way of example, to the accompanying drawings.

With specific reference now to the drawings in detail, it is stressed that the particulars shown are by way of example and for purposes of illustrative discussion of the preferred embodiments of the present invention only, and are presented in the cause of providing what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention may be embodied in practice. In the accompanying drawings:
Figure 1 shows the architecture of a typical digital camera.
Figure 2 is a simplified block diagram of an image capture apparatus, according to a preferred embodiment of the present invention.
Figure 3 is a simplified block diagram of a preferred embodiment of an image capture apparatus, according to a further preferred embodiment of the present invention.
Figure 4 is a simplified flowchart of a method for providing a backup copy of captured image data.
Figure 5 is a simplified flowchart of a method for storing a predetermined number of most recently captured images in a recent image memory.

In current digital camera technology sensor image data is generally stored in a temporary buffer memory and written, processed or unprocessed, into a non-volatile memory device. The non-volatile memory is usually removable, and its typically small size increases the possibility that the memory may be physically damaged or even lost. Camera memory failure can occur even with proper handling of the non-volatile memory. Memory port failure can cause incorrect download of image data. Additionally, the image data can be lost at various stages of the image processing, for example during image compression or resolution reduction.

In the current embodiments the image data is automatically duplicated onto two or more memory devices. The photographer may then remove some or all of the non-volatile devices and keep them separately, to ensure that if one copy of the image is lost or damaged the rest still exist. The possibility of image loss due to memory damage, malfunction, or misplacement is thus significantly reduced, protecting the user from the loss of non-recurring scene images.

Before explaining at least one embodiment of the invention in detail, it is to be understood that the invention is not limited in its application to the details of construction and the arrangement of the components set forth in the following description or illustrated in the drawings. The invention is applicable to other embodiments or of being practiced or carried out in various ways. Also, it is to be understood that the phraseology and terminology employed herein is for the purpose of description and should not be regarded as limiting.

The degree to which duplicating images within camera memory is useful to camera users is highly dependent upon two factors: the time required to store an image in memory, and memory capacity. If image storage time is extended, storage of backup copies of the image may cause a noticeable delay. This delay is an inconvenience to any user, but is untenable to photographers in rapidly changing, time-critical situations. Memory capacity limits the number of images that can be stored in camera memory. If the number of images which can be stored in camera memory is small, storing a backup copy of the image in addition to the primary copy significantly limits the number of different images which can be photographed before the memory must be replaced or downloaded. Due to recent improvements in camera memory technology, memories which can store hundreds of images are available for both professional and home use digital cameras. Image data transfer and write speed into memory has increased, so that the time required to store multiple copies of an image is correspondingly decreased. With current improvements in digital camera and non-volatile memory technology, on-camera image backup becomes technologically feasible.

Reference is now made to Figure 2, which is a preferred embodiment of a simplified block diagram of an image capture apparatus 200. The image capture apparatus 200 consists of an image capture sensor 210, a memory bank 220 containing a plurality of memory units 230.1 to 230.n, and a memory controller 240. Light entering image capture apparatus 200 is captured by sensor 210. Memory controller 240 transfers the current image data from the sensor, for storage in memory bank 220. However, rather than storing a single copy of the image, memory controller 240 stores the complete current image in two or more memory units 230 within memory bank 220. Thus one or more backup copies of the current image are created.

In the preferred embodiment the connection between the controller and the memory units 230 may be physical or via a wireless connection, such as a BlueTooth communication channel. The controller inside image capture apparatus 200 may write the data into the multiple memory units 230 in parallel, for example via a split data bus. Alternatively, the image copies may be stored sequentially, that is the image is first stored in memory unit 230.1, and then in memory unit 230.2, and so forth, until the desired number of copies have been stored. The memory units specified are for purposes of example only, and the image data may be stored in any of the available memory units, 230.1...230.n, in any order desired by the user. In another preferred embodiment, memory controller 240 stores a first copy of the current image immediately upon sensor readout, and later creates one or more backup copies during apparatus idle time.

In the preferred embodiment memory units 230 are non-volatile memories, such as flash or compact flash memory, smart card, or a hard drive. Typically one or more of the memory units 230 are physically separable and/or removable. After removing a memory unit 230, the user may then insert a new memory unit for additional image storage. Physically separating the memory units separates the copies of the images, and provides greater protection.

In the preferred embodiment one or more of the non-volatile memory units may be set to serve as additional storage or as redundant backup storage by user choice. Camera functions relating to image backup, such as turning an automatic image backup mode on and off, may be under user control. The user may also select the number of backup copies created, conditional upon the number of memory units and available memory.

In the preferred embodiment, one of the memory units, preferably non-removable, stores a specified number of the most recently captured images. The recent image memory thus serves as an automatic backup of the last "roll of film" taken. If storing a new image would exceed the specified number, the oldest image stored is deleted prior to storing the new image. With an appropriate command, the memory controller 240 copies the contents of the recent image memory into a different, preferably removable, non-volatile memory unit within the memory bank 220.

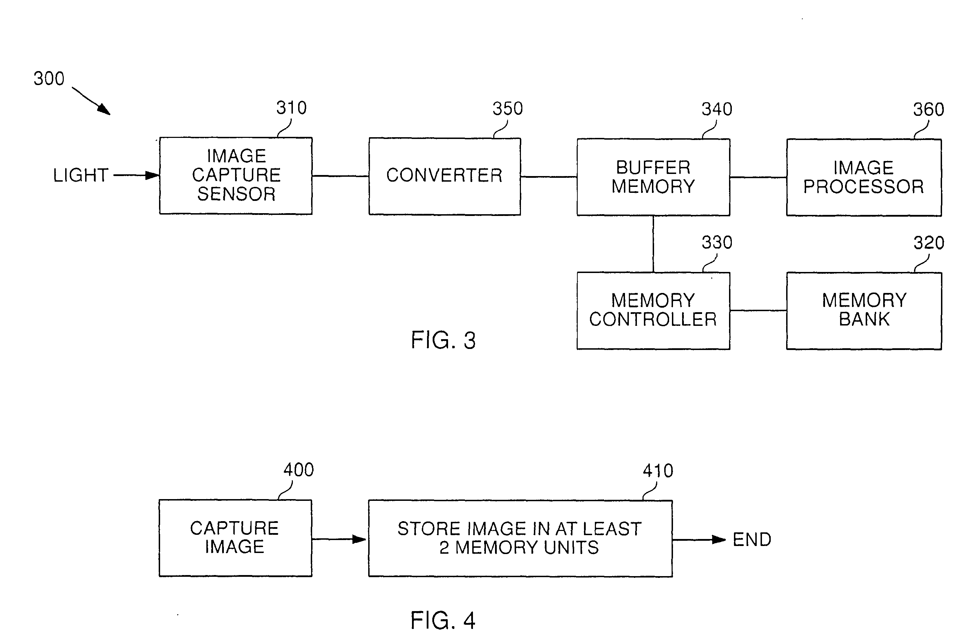

Reference is now made to Figure 3, which is a simplified block diagram of a further preferred embodiment of an image capture apparatus 300, such as a digital camera. Image capture apparatus 300 consists of image capture sensor 310, a memory bank 320, and a memory controller 330, as discussed above. In the preferred embodiment image capture apparatus 300 further consists of, separately or in combination, buffer memory 340, converter 350, and image processor 360.

In the preferred embodiment buffer memory 340 serves for temporary storage of raw image data from the sensor 310. The raw sensor data may be digitized by converter 350 prior to being stored in the buffer memory 340. Image processor 360 performs various types of processing of the raw image data, such as adjusting for known sensor non-uniformity, image compression and resolution reduction, and matching different data rates of reading from the sensor and writing into the non-volatile memory device.

The images stored in memory bank 320 may be processed or unprocessed. For example, in addition to the backup operation as described above, a lossy compressed, lossless compressed, or lower resolution image may be saved for each captured image. Image processor 360 may substantially compress the captured digital images, and the compressed images may then be stored in nonvolatile memory, either on-camera or in removable memory. The compressed images may serve as additional backup.

Reference is now made to Figure 4, which is a simplified flowchart of a preferred embodiment of a method for providing a backup copy of captured image data. A current image is captured in step 400. In step 410 the current image is stored in two or more memory units. At least two copies of the image data are generated, thus providing image data backup. The current image can be stored in each of the memories in parallel or sequentially. The memory units are preferably nonvolatile memories.

The preferred embodiment also contains the further steps of digitizing and processing the image, and of downloading images from the memory units to a computer or other processing device. Additionally, the number of memory units in which copies of the image are stored may be specified by a user.

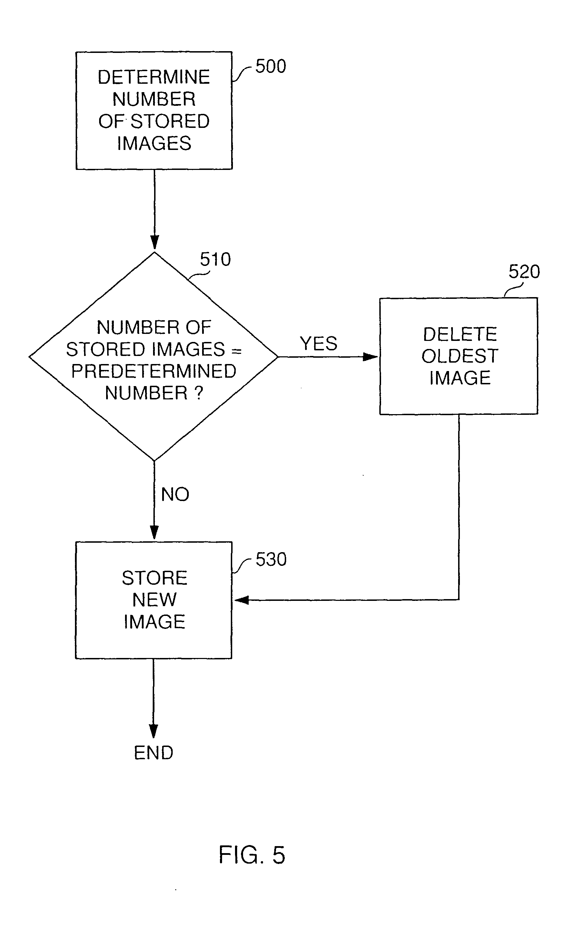

Reference is now made to Figure 5, which is a simplified flowchart of a preferred embodiment of a method for storing a predetermined number of most recently captured images in a recent image memory. The following method is performed when a new image has been captured, and is ready for storage in the recent image memory. First, in step 500 the number of images currently stored in the recent image memory is determined. In step 510 the number of images in the recent image memory is compared to the predetermined number. If the numbers are equal, the least recent image is deleted from the recent image memory in step 520. Finally, the new current image is stored in the recent image memory in step 530.

The following example illustrates one possible implementation of automatic image backup in a digital camera.

### Automatic backup mode

1) The user selects the automatic backup mode on the digital camera.
2) The user sets the camera to the desired settings, and presses the Shoot button on the camera or the camera back. A single image is taken. After these steps, camera operation is completely automatic.
3) The image is captured by the sensor, digitized by the A/D converter, and stored in the buffer memory.
4) A primary copy of the image is created by compressing the data in the buffer into a JPEG image, without erasing the raw image data from the buffer memory. The JPEG image is then stored in a primary memory unit.
5) The raw image data in the buffer is now used to create one or more backup copies of the image. The backup copies may consist of raw image data or image data after backup processing.

The type of backup image saved is significant. Saving the raw image data from the buffer provides the greatest protection, as it prevents errors due to image processing failures in addition to memory loss or malfunction. However a relatively large amount of memory is required to store the uncompressed image. Backup processing of the buffer memory data can reduce the amount memory needed for the backup copy. Storing a backup of the JPEG image is fastest, as the buffer memory download and image processing are done to create the primary JPEG image, but is most vulnerable as the two copies formed are not created independently from the raw image data.

Backup memory functionality is an important extension of current digital camera technology, and one that is of great significance to camera users. Digital cameras can be easily modified to include backup memory. The primary change required is to change the controller operation to support the "simultaneous writing" of images into more than a single non-volatile memory device. This can be done, in the case of a microprocessor serving as controller, by modifying the control software so as to write each line to two or more devices, or to write the complete file first to one device and then to another. Image backup cannot be provided on-camera by film cameras, and will contribute to the growing popularity of digital cameras in private and commercial use.

It is appreciated that certain features of the invention, which are, for clarity, described in the context of separate embodiments, may also be provided in combination in a single embodiment. Conversely, various features of the invention which are, for brevity, described in the context of a single embodiment, may also be provided separately or in any suitable subcombination.

It will be appreciated by persons skilled in the art that the present invention is not limited to what has been particularly shown and described hereinabove. Rather the scope of the present invention is defined by the appended claims and includes both combinations and subcombinations of the various features described hereinabove as well as variations and modifications thereof which would occur to persons skilled in the art upon reading the foregoing description.

## Claims

1. Image capture apparatus, comprising:
an image capture sensor, for capturing a current image;
a memory bank, comprising more than one memory units, for storing image data; and
a memory controller, operatively associated with said sensor and said memory bank, for storing said current image in each of at least two of said memory units,
thereby to provide a backup copy of said image data.

2. Image capture apparatus according to claim 1, wherein said memory units comprise non-volatile memory.

3. Image capture apparatus according to claim 2, wherein said non-volatile memory is one of a group comprising: flash memory, compact flash memory, smart card, and hard drive.

4. Image capture apparatus according to claim 1, 2 or 3, wherein at least one of said memory units is removable.

5. Image capture apparatus according to any preceding claim, wherein said memory units are physically separable.

6. Image capture apparatus according to any preceding claim, wherein said image capture apparatus is operable to store said current image in said memory units in parallel.

7. Image capture apparatus according to any preceding claim, wherein said image capture apparatus is operable to store said current image in said memory units sequentially.

8. Image capture apparatus according to any preceding claim, wherein one of said memory units comprises a recent image memory operable to store a predetermined number of most recently captured images, and wherein if storing a new current image in said recent image memory would exceed said predetermined number, a least recent image is removed from said recent image memory prior to storing said current image.

9. Image capture apparatus according to any preceding claim, wherein said memory controller is operable to store said backup copy of said current image during image capture apparatus idle time.

10. Image capture apparatus according to any preceding claim, further comprising a converter, for converting current image data from said sensor into a digitized image.

11. Image capture apparatus according to any preceding claim, further comprising a buffer memory, for providing temporary storage of said current image.

12. Image capture apparatus according to any preceding claim, further comprising an image processor for processing image data.

13. Image capture apparatus according to claim 12, wherein said image processor is operable to perform said processing separately on said backup copy of said image, thereby to provide a processed backup copy of said image data.

14. Image capture apparatus according to claim 12, wherein said processing is performed upon data stored in a buffer memory.

15. Image capture apparatus according to claim 12, wherein said processing comprises image compression.

16. Image capture apparatus according to claim 12, wherein said processing comprises compensation for sensor non-uniformity.

17. Image capture apparatus according to claim 12, wherein said processing comprises data rate matching to compensate for unequal rates of reading data from said sensor and storing said sensor data in said memory units.

18. Image capture apparatus according to claim 12, wherein said processing comprises image resolution reduction.

19. Image capture apparatus according to any preceding claim, wherein at least one of said memory units is switchable between storing primary copies of images and storing backup copies of images, thereby to provide primary image memory expansion capability.

20. Image capture apparatus according to any preceding claim, wherein a number of backup copies provided is user selectable.

21. A method for providing a backup copy of captured image data, comprising:
capturing a current image; and
storing said current image in each of at least two memory units.

22. A method for providing a backup copy of captured image data according to claim 21, wherein said memory units are non-volatile memories.

23. A method for providing a backup copy of captured image data according to claim 21 or 22, wherein said memory units are physically separable.

24. A method for providing a backup copy of captured image data according to claim 21 22, or 23, wherein storing said current image in said memory units comprises storing said current image data in said memory units sequentially.

25. A method for providing a backup copy of captured image data according to any one of claims 21 to 24, wherein storing said current image in said memory units comprises storing said current image data in said memory units in parallel.

26. A method for providing a backup copy of captured image data according to any one of claims 21 to 25, wherein one of said memory units comprises a recent image memory for storing a predetermined number of most recently captured images, and wherein storing a new current image in said recent image memory comprises:
determining a number of images stored in said recent image memory;
if said number of images equals said predetermined number, removing a least recent image from said recent image memory; and
storing said new current image in said recent image memory.

27. A method for providing a backup copy of captured image data according to any one of claims 21 to 26, further comprising digitizing said current image.

28. A method for providing a backup copy of captured image data according to claim 21 to 27, further comprising processing image data.

29. A method for providing a backup copy of captured image data according to claim 28, wherein processing image data comprises compressing said image data.

30. A method for providing a backup copy of captured image data according to claim 28, wherein processing image data comprises compensating for sensor non-uniformity.

31. A method for providing a backup copy of captured image data according to claim 28, wherein processing image data comprises matching data rates to compensate for unequal rates for reading sensor data and storing said sensor data in said memory units.

32. A method for providing a backup copy of captured image data according to claim 28, wherein processing image data comprises reducing image resolution.

33. A method for providing a backup copy of captured image data according to any one of claims 21 to 32, further comprising downloading image data from at least one of said memory units to a computer.

34. A method for providing a backup copy of captured image data according to any one of claims 21 to 33, further comprising selecting a number of backup copies to be stored in said memory units.
